# DEMANDE DE BREVET EUROPEEN

(11) **EP 4 753 406 A1**
(43) Date de publication de la demande: **03.06.2026**
(21) Numéro de dépôt: 25215529.6
(22) Date de dépôt: 13.11.2025
(51) Int. Cl.: H10F 39/00, H10F 39/12, H10F 77/30

(54) **PIXEL SEMICONDUCTEUR COMBINANT RÉSEAU DE DIFFRACTION ET FILTRE INTERFÉROMÉTRIQUE, CAPTEUR D'IMAGES**

(30) Priorité: 27.11.2024 FR 2413055
(71) Demandeur: STMicroelectronics International N.V., 1228 Plan-les-Ouates, Geneva (CH)
(72) Inventeur: BARDONNET, Félix, 38000 Grenoble (FR)
(74) Mandataire: Casalonga

(57) **Abrégé**

Un capteur d'images est constitué de pixels rétroéclairés (110) formés dans et sur un substrat semiconducteur (101). Un rayonnement dans le domaine infrarouge proche atteint le photodétecteur rétroéclairé (112) des pixels via une surface éclairée supérieure (102) du photodétecteur. Une structure hybride combinant réseau de diffraction (114) au niveau de cette surface supérieure et filtre interférométrique à couches non-régulières (115) déposé sur le réseau de diffraction permet de piéger les photons dans le silicium du photodétecteur. Le rayonnement est diffracté dans le photodétecteur avec un angle suffisant pour qu'après réflexion sur des tranchées (113) isolant les photodétecteurs adjacents et sur la couche métallique (111) déposée sur la surface opposée du photodétecteur rétroéclairé, il soit réfléchi par le filtre interférométrique. Les photons sont piégés dans le substrat ; leur absorption et donc le rendement quantique du pixel rétroéclairé sont améliorés.

## Description

### DOMAINE TECHNIQUE

Des modes de réalisation et de mise en œuvre concernent le domaine des capteurs d'images, typiquement de caméras opérant dans l'infrarouge proche.

### CONTEXTE TECHNIQUE

Un capteur photographique ou d'images, type CMOS (pour « complementary metal-oxide-semiconductor » ou « semi-conducteur complémentaire à oxyde de métal ») comprend classiquement une pluralité de pixels, par exemple agencés en matrice selon des lignes et des colonnes, intégrés dans et sur un substrat semiconducteur.

Chaque pixel comprend classiquement une zone photosensible ou « photosite » - par exemple une photodiode - formée dans le substrat semiconducteur et agissant comme photodétecteur, c'est-à-dire qui absorbe un rayonnement électromagnétique incident et le convertit en signal électrique. Les signaux électriques des pixels sont traités et assemblés pour former une image.

Les photodétecteurs des pixels sont séparés latéralement les uns des autres, électriquement et/ou optiquement, par des tranchées ou murs d'isolation réalisés dans le substrat. Une électrode (ou plus généralement des couches métalliques) est généralement située sur une face du photodétecteur pour relier le photodétecteur aux circuits de décodage.

Il est connu que le silicium composant le photodétecteur présente une excellente absorption des rayonnements dans le domaine visible (380 à 780 nanomètres - nm). Cependant, celle-ci faiblit fortement dans le domaine de l'infrarouge proche (ou NIR pour « near infra-red », vers 850-1000 nm) et plus précisément autour de 940 nm où se trouvent nombre d'applications, notamment les détecteurs de distance type FaceID, LIDAR, etc..

Pour éviter de détecter les longueurs d'onde indésirables (par exemple le visible), les technologies actuelles utilisent des filtres NIR dans le module, généralement déposés sur les lentilles du module qui font converger le rayonnement électromagnétique incident vers les pixels. Ces opérations de dépôt des filtres NIR sur les lentilles du module sont complexes et représentent des coûts de conception non négligeables.

Par ailleurs, le faible rendement quantique du silicium dans le domaine NIR nuit à la qualité des images acquises par le capteur.

Il existe un besoin d'améliorer cette situation.

### RESUME

Dans ce dessein, il est proposé un pixel semiconducteur comprenant :
un substrat,
un photodétecteur rétroéclairé dans le substrat entre une première surface éclairée du substrat et une deuxième surface du substrat en contact avec une couche métallique et opposée à la première surface éclairée,
une structure de diffraction sur le photodétecteur rétroéclairé, formée au niveau de la première surface éclairée du substrat, et
un filtre interférométrique déposé sur la structure de diffraction.

Un capteur rétroéclairé ou à éclairement par la face arrière ou capteur BSI (de l'anglais « Back Side Illumination ») est un capteur dans lequel les rayons lumineux en provenance de la scène à imager atteignent le substrat par sa face opposée à un empilement d'interconnexion comprenant des éléments d'interconnexion (tels des électrodes et couches métalliques) des pixels du capteur. La surface « éclairée » d'un pixel désigne donc la face par laquelle les rayons lumineux en provenance de la scène à imager arrivent.

On entend par « filtre interférométrique » un empilement de couches minces diélectriques (et/ou métalliques) alternées, d'indices de réfraction différents. Un tel filtre permet généralement de filtrer une bande souhaitée de longueurs d'onde. Le filtre interférométrique est par ailleurs extrêmement sensible à l'angle d'incidence du rayonnement lumineux, le coefficient de transmission du filtre diminuant rapidement avec l'angle et se décalant alors vers des longueurs d'onde plus petites.

Aussi, en prévoyant un tel filtre interférométrique directement sur la structure de diffraction du photodétecteur rétroéclairé, le rayonnement incident filtré est dévié par la structure de diffraction dans le substrat du photodétecteur. Malgré des réflexions dans le substrat (notamment par la couche métallique sur la seconde surface) et de la diffraction sur la ou les couches métalliques opposées à la face éclairée, le rayonnement ou une importante partie de celui-ci (selon le design de la structure de diffraction) conserve un angle d'incidence lorsqu'il revient vers le filtre interférométrique, empêchant une transmission retour. Les photons sont donc piégés au sein du substrat du photodétecteur rétroéclairé. L'absorption de ceux-ci et donc le rendement quantique QE du pixel rétroéclairé s'en trouvent substantiellement améliorés.

En outre, en combinant directement le filtre interférométrique et la structure de diffraction, on obtient une structure hybride compacte de piégeage des photons.

Selon un autre aspect, il est proposé un procédé de fabrication d'un pixel semiconducteur, comprenant les étapes suivantes :
former un photodétecteur rétroéclairé dans un substrat, entre une première surface éclairée du substrat et une deuxième surface du substrat en contact avec une couche métallique et opposée à la première surface éclairée,
former une structure de diffraction sur le photodétecteur rétroéclairé, au niveau de la première surface éclairée du substrat, et
former, par dépôts successifs de couches minces, un filtre interférométrique sur la structure de diffraction.

Il est également proposé un capteur d'images comprenant une pluralité de pixels semiconducteurs tels que définis dans la présente divulgation.

Des caractéristiques facultatives de modes de réalisation sont définies ci-après en référence au dispositif, tandis qu'elles peuvent être transposées en caractéristiques de procédé.

Dans un mode de réalisation, le filtre interférométrique est formé d'un empilement de couches non-régulières. Cette irrégularité des couches de diélectrique (irrégularité en épaisseur notamment) permet d'ajuster la sélectivité angulaire de transmission du filtre dans une bande souhaitée de longueurs d'onde. Cette disposition permet notamment d'adapter le filtre interférométrique à l'ouverture angulaire de la lentille principale du capteur pour éclairer l'ensemble des pixels.

Dans un mode de réalisation, le substrat est formé de silicium. Le silicium présente avantageusement un indice de réfraction élevé à 940 nm (3,6 contre 1 pour l'air), assurant une réflexion totale des photons au-delà d'un certain angle limite assez faible. Aussi, le piégeage des photons est amélioré.

Dans un mode de réalisation, la structure de diffraction est conçue pour diffracter un rayonnement incident de longueur d'onde donnée avec un angle diffracté qui est supérieur à un angle, à la normale, minimal de réflexion cible du filtre interférométrique pour la longueur d'onde donnée au niveau de l'interface avec la structure de diffraction. Cet angle minimal peut typiquement être l'angle limite défini à l'interface entre le substrat et la première couche du filtre interférométrique. Une telle configuration augmente encore le piégeage des photons dans le substrat. La « réflexion cible » peut viser un taux seuil faible voire quasi-nul (tel que 1% voire quelques pourcents) pour obtenir une réflexion quasi-totale au-delà dudit angle minimal.

Dans un mode de réalisation, la structure de diffraction comprend un réseau de diffraction réalisé sur la première surface éclairée du photodétecteur rétroéclairé. Par exemple, le réseau de diffraction peut présenter un pas (ou période) compris entre 400 et 500 nm, de sorte à diffracter un rayonnement NIR d'un angle d'environ 30°, adapté à une forte (voire totale) réflexion par le filtre interférométrique. A titre d'exemple, avec un tel pas dans un substrat silicium, un seul ordre est diffracté à 940 nm, entre 30° et 45°.

Dans un mode de réalisation, le substrat comprend une (ou plusieurs) tranchée d'isolation autour du photodétecteur rétroéclairé, par exemple en SiO₂, pour l'isoler optiquement d'un ou plusieurs photodétecteurs rétroéclairés de pixels adjacents. La présence d'une ou plusieurs tranchées d'isolation en bordure du photodétecteur rétroéclairé limite la diaphosie (ou « crosstalk » en langue anglo-saxonne) entre pixels voisins, et renforce ainsi le piégeage des photons dans chaque pixel. Le rendement quantique QE du pixel s'en trouve amélioré.

### BREVE DESCRIPTION DES FIGURES

D'autres avantages et caractéristiques de l'invention apparaîtront à l'examen de la description détaillée de mode de réalisation et de mise en œuvre, nullement limitatifs, et des dessins annexés sur lesquels :
[Fig. 1] ;
[Fig. 2] ;
[Fig. 3] ;
[Fig. 4A] ;
[Fig. 4B] ;
[Fig. 5A] ;
[Fig. 5B] ;
[Fig. 6A] ;
[Fig. 6B] ; et
[Fig. 7] illustrent schématiquement des modes de mise en œuvre et de réalisation de l'invention.

### DESCRIPTION DETAILLEE

De mêmes éléments sont désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits sont représentés et détaillés. En particulier, les circuits électroniques de décodage et de contrôle des capteurs d'images décrits ne sont pas détaillés, les modes de réalisation décrits étant compatibles avec les réalisations usuelles de ces éléments. Par ailleurs, le module comprenant des lentilles principales focalisant le rayonnement sur des sous-groupes de pixels n'est pas nécessairement représenté, mais peut être conforme aux réalisations usuelles, incluant par un exemple des lentilles d'ouverture numérique F#2. En outre, les applications que peuvent avoir les capteurs d'images décrits ne sont pas détaillées.

Dans la description qui suit, lorsqu'il est fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Selon un aspect des modes de réalisation décrits, on prévoit un capteur d'images constitué de pixels rétroéclairés formés dans et sur un substrat semiconducteur. Un rayonnement dans le domaine infrarouge proche atteint le photodétecteur rétroéclairé des pixels via une surface éclairée supérieure du photodétecteur. Une structure hybride combinant réseau de diffraction au niveau de cette surface supérieure et filtre interférométrique à couches non-régulières déposé sur le réseau de diffraction permet de piéger les photons dans le silicium du photodétecteur. Le rayonnement est diffracté dans le photodétecteur avec un angle suffisant pour qu'après réflexion sur des tranchées isolant les photodétecteurs adjacents et sur la couche métallique déposée sur la surface opposée du photodétecteur rétroéclairée, il soit réfléchi par le filtre interférométrique. Les photons sont piégés dans le substrat ; leur absorption et donc le rendement quantique du pixel rétroéclairé sont améliorés.

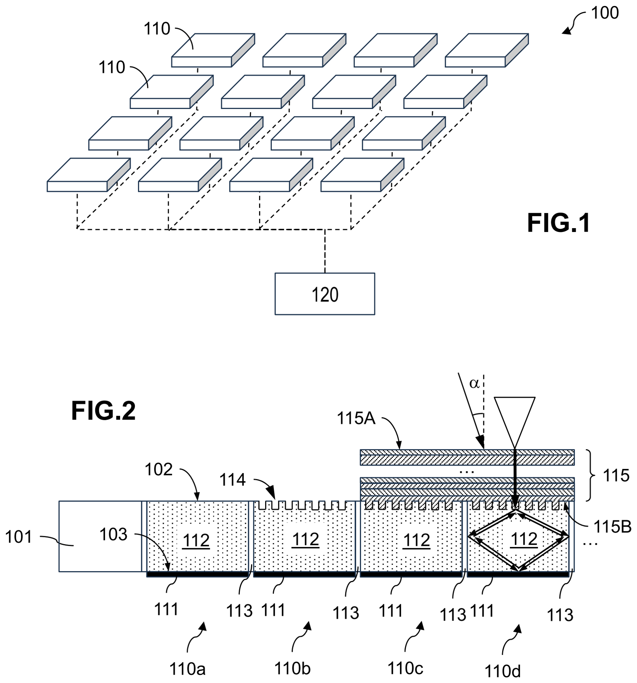

Les **Figure 1** et **Figure 2** illustrent, en perspective et en coupe, un capteur d'images 100 formé dans et sur un substrat semiconducteur 101, par exemple en silicium, par exemple en silicium monocristallin. Les modes de réalisation décrits ne se limitent toutefois pas à cet exemple particulier. A titre de variante, le capteur 100 peut être réalisé à base d'un substrat en un matériau semiconducteur de type III-V, d'un film quantique, ou de tout matériau photosensible connu, organique ou inorganique.

Le capteur comprend une pluralité de pixels (ou capteur pixel) 110, par exemple agencés en matrice selon des lignes et des colonnes. Les pixels du capteur sont par exemple tous identiques, aux dispersions de fabrication près, ou similaires.

Le capteur 100 est un capteur rétroéclairé ou à éclairement par la face arrière ou capteur BSI : le rayonnement lumineux en provenance de la scène à imager atteint le substrat par sa face arrière, c'est à dire sa face opposée à un empilement d'interconnexion comprenant des couches métalliques d'interconnexion des pixels du capteur à des décodeurs de pixels. Les capteurs rétroéclairés s'opposent aux capteurs à éclairement par la face avant ou capteur FSI (de l'anglais « Front Side Illumination »).

Chaque pixel rétroéclairé 110 comprend un photodétecteur rétroéclairé 112 formé dans le substrat 101 entre une première surface 102 du substrat, dite surface « éclairée », et une deuxième surface 103 du substrat opposée à la première surface, dite surface « d'interconnexion » dans la mesure où elle est en contact avec l'empilement d'interconnexion et donc une couche métallique.

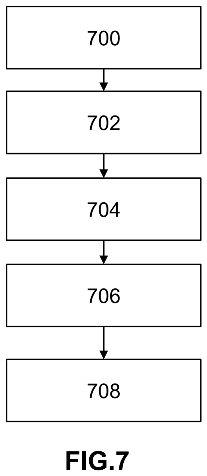

La **Figure 2** illustre des pixels rétroéclairés dans des états différents de fabrication à des fins d'illustration. En pratique, plusieurs pixels sont élaborés en parallèle sur un même substrat 101, de sorte que tous les pixels sont dans le même état de fabrication à un instant donné. Les étapes de fabrication du capteur 100 sont décrites par la suite en référence à la **Figure 7**.

Pour simplifier les illustrations, la zone entière 112 du substrat d'un pixel rétroéclairé 110 est représentée comme correspondant au photodétecteur rétroéclairé. Néanmoins, en pratique, la zone active du photodétecteur rétroéclairé 112 peut ne représenter qu'une portion seulement de la zone du substrat du pixel rétroéclairé.

Le photodétecteur rétroéclairé 112 est typiquement une photodiode comprenant, dans le substrat semiconducteur 101 (d'épaisseur 6 µm par exemple), une région semiconductrice dopée P entourant au moins partiellement une région semiconductrice dopée N, formant ainsi une jonction PN. La région dopée N s'étend depuis la surface éclairée, ici supérieure, 102 du substrat 110 jusqu'à une profondeur (par exemple 2,5 µm) dans la région dopée P.

Comme illustré, le photodétecteur rétroéclairé 112 a sensiblement la forme d'un pavé.

Chaque pixel comprenant, sur la surface d'interconnexion 103, une ou plusieurs électrodes 111 reliées à des circuits de contrôle et de décodage 120 pour acquérir un signal du pixel. De façon générale, une couche métallique est déposée sur la surface d'interconnexion 103 du substrat.

Dans l'exemple représenté, des tranchées ou murs d'isolation 113 (ou CDTI pour « Capacitor Deep Trench Isolation »), s'étendant verticalement dans le substrat 101, séparent latéralement les uns des autres, électriquement et/ou optiquement, les photodétecteurs rétroéclairés 112 des pixels, pour limiter la diaphosie entre pixels adjacents. Typiquement, des tranchées profondes d'isolation peuvent être formées dans un substrat par gravure du substrat, suivi d'un dépôt d'un ou plusieurs matériaux diélectriques (tels que le dioxyde de silicium SiO₂). Un excès de diélectrique peut être supprimé à l'aide de techniques appropriées, telles la planarisation chimico-mécanique.

Dans cet exemple, un pixel rétroéclairé 110 comprend une structure de diffraction 114, présentant notamment un motif de structuration périodique ou régulier - tel un réseau de diffraction, sur le photodétecteur rétroéclairé, formée au niveau de la surface éclairée 102. La structure de diffraction 114 peut être constituée de plots formés par gravure sèche du substrat 101 au niveau de la première surface 102. En variante, des pyramides peuvent être formées à l'aide d'une gravure humide.

L'homme de l'art connaît des formules de diffraction de réseau simple lui permettant de déterminer le dimensionnement de ce réseau (notamment largeur et hauteur des plots ainsi que leur pas ou période) en fonction d'une longueur d'onde (ou d'une bande) donnée et d'un angle de diffraction cible.

A titre illustratif, pour une application dans le domaine infrarouge proche (NIR), un seul ordre à 940 nm est diffracté, d'un angle de diffraction compris entre 30° et 45°, par un réseau de diffraction réalisé dans un substrat de silicium présentant un pas de 400 à 500 nm. Le réseau de diffraction peut présenter des plots de largeur 200 nm environ et de hauteur comprise entre 200 et 400 nm. Ces valeurs sont bien entendu uniquement des exemples. Par ailleurs, la longueur d'onde de 940 nm est indiquée à titre préférentiel. Cependant, d'autres longueurs d'onde dans le NIR, typiquement entre 850 nm et 1000 nm peuvent être considérées.

Dans l'exemple illustré, le pixel rétroéclairé 110 comprend enfin un filtre interférométrique 115 déposé sur la structure de diffraction 114. Le filtre a vocation à filtrer une bande étroite de NIR, par exemple autour de 940 nm. Le filtre interférométrique 115 peut former une structure d'épaisseur comprise entre 1 et 10 µm, même si des épaisseurs inférieures ou supérieures sont également envisageables.

Le filtre interférométrique 115 est constitué d'un empilement de couches minces alternées, d'indices de réfraction différents. Typiquement, on alterne deux matériaux diélectriques différents. A titre d'exemple, le nombre de couches minces peut être compris entre 2 et 100, par exemple entre 5 et 50.

A titre illustratif, les couples suivants de matériaux peuvent être utilisés :
- SiO₂ et TA₂O₅,
- SiO₂ et a-SI (silicium amorphe),
- SiO₂/Nb₂O₅,
- SiO₂/SiN.

De préférence, le filtre interférométrique est formé d'un empilement de couches non-régulières en ce que les épaisseurs d'une couche à l'autre sont irrégulières et ne suivent pas un motif régulier. L'irrégularité des couches permet d'ajuster la plage d'angles d'incidence effectivement transmise par le filtre, pour répondre notamment à des besoins variables d'ouverture angulaire pour éclairer l'ensemble des pixels.

La conception du filtre interférométrique 115 peut être assistée par ordinateur (typiquement en utilisant un logiciel à couche mince - « thin-film software » - tel que Optilayer ou OTF Studio, noms commerciaux) compte tenu de la longueur d'onde utilisée (e.g., 940 nm) et d'une largeur de bande cible à mi-hauteur du diagramme de transmission (par exemple 23 nm). La conception cherche notamment à maximiser la transmission sur une bande de longueurs d'ondes autour de la longueur d'onde souhaitée, pour une plage d'angles d'incidence souhaitée, par exemple 0° à 14° ou 0° à 30°. En effet, le filtre interférométrique est sensible à l'angle d'incidence du rayonnement lumineux, le coefficient de transmission du filtre diminuant rapidement avec l'angle et se décalant alors vers des longueurs d'onde plus petites. Aussi, plage d'angles d'incidence transmis et largeur de bande cible à mi-hauteur sont étroitement liées : plus la largeur de bande à mi-hauteur est élevée, plus la plage d'angles d'incidence α (angle à la normale à la surface) garantissant une transmission par le filtre est grande. On peut ainsi définir un angle d'incidence minimal de réflexion (quasi-)totale à partir duquel la transmission du rayonnement à la longueur d'onde cible est considéré comme trop faible (par rapport à un seuil par exemple). L'angle d'incidence minimal de réflexion (quasi-)totale sur l'interface filtre-air (donc sur la surface 115A pour le trajet aller correspondant à un rayonnement lumineux en provenance de la scène à imager) est noté α₀.

De façon symétrique, on peut noter α₁ l'angle d'incidence minimal de réflexion (quasi-)totale sur l'interface substrat-filtre (donc sur la surface 115B pour le trajet retour correspondant au rayonnement lumineux renvoyé par le substrat) puisque le filtre interférométrique 115 est déposé sur le substrat 101.

La conception du filtre interférométrique 115 peut prendre en compte les angles α₀ et α₁ en plus de la largeur de bande à mi-hauteur.

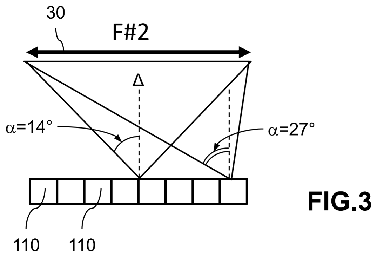

La **Figure 3** illustre par exemple un agencement de capteur d'images 100 dans lequel le rayonnement est focalisé sur toute ou partie de la matrice de pixels 110 à l'aide d'une lentille principale 30, e.g. d'ouverture numérique F#2. Cette lentille illumine les pixels du centre avec un angle d'incidence maximal de 14° (α=14° par rapport à la normale Δ), et les pixels les plus au bord avec un angle d'incidence maximal compris entre 25 et 30°, par exemple 27° (α=27°).

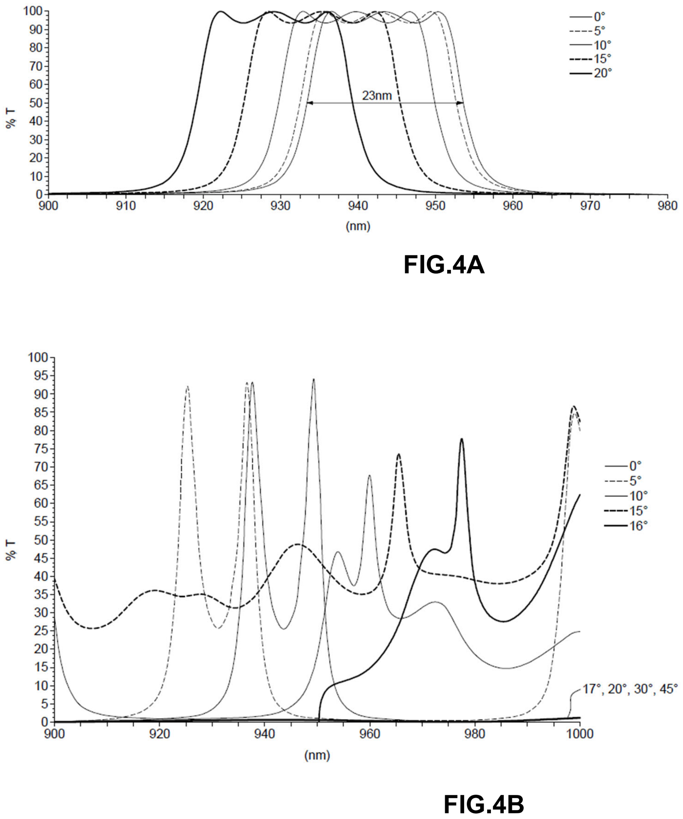

Les **Figure 4A** et **Figure 4B** représentent des diagrammes de transmission d'un exemple de filtre interférométrique déposé sur un substrat de silicium. Le filtre interférométrique est à couches SiO₂ et TA₂O₅ non-régulières, conçu par ordinateur pour une bande de longueurs d'onde autour de 940 nm, un cône d'illumination en F#2, et un angle α₀ de 14°. La **Figure 4A** représente la transmission avec un cône d'incidence F#2, correspondant donc sensiblement au sens aller (rayons lumineux en provenance de la scène), et la **Figure 4b** sans cône d'incidence, correspondant donc sensiblement au sens retour (rayons en provenance du substrat 101).

Le filtre interférométrique 115 dans cet exemple est formé de 35 couches minces non-régulières alternées de SiO₂ et TA₂O₅, pour une épaisseur totale d'environ 6 µm. Les diagrammes sont obtenus par simulation de la transmission de rayonnements NIR (lumière collimatée) dans ce filtre en fonction de différents angles d'incidence α, à l'aide du logiciel Lumerical (nom commercial).

La **Figure 4A** montre que le filtre interférométrique est un filtre passe-bande présentant une largeur de bande à mi-hauteur de 23 nm. Il présente également une bonne tolérance à la transmission (90% ou plus) au moins jusqu'à un angle de 15°, environ jusqu'à 17-18°. Aussi, un tel filtre apparaît adapté à une configuration de capteur d'images où l'angle maximale d'incidence du rayonnement α (e.g. depuis la lentille principale F#2) est limité à 17-18°. Dans ce cas, l'angle d'incidence minimal de réflexion (quasi-)totale pour le trajet aller est α₀=17°.

La **Figure 4B** montre que jusqu'à un angle d'incidence de 16°, le rayonnement est en partie transmis par le filtre interférométrique. Au-delà de 16°, la transmission est quasi nulle. Dans ce cas, l'angle d'incidence minimal de réflexion (quasi-)totale pour le trajet retour est α₁=16°. La (quasi-)totale réflexion en sens retour provient notamment des propriétés du silicium qui, avec un indice de réfraction élevé, assure une réflexion totale au-delà d'un certain angle : les photons qui frappent la surface inférieure 115B du filtre interférométrique 115 avec un angle supérieur à α₁ sont tous réfléchis et demeurent dans le photodétecteur 112.

C'est le phénomène illustré par les flèches dans le pixel 110d de la **Figure 2**. Lorsque le rayonnement NIR incident est transmis par le filtre interférométrique 115 vers le photodétecteur 112, il est dévié d'un angle, e.g. 30°, supérieur à α₁ par la structure de diffraction 114. Compte tenu de la géométrie du photodétecteur (typiquement un pavé), les tranchées latérales d'isolation 113 et la couche métallique 111 sur la surface inférieure du pixel 110 assurent une réflexion des photons dans le photodétecteur 112, lesquels reviennent frapper la surface inférieure 115B du filtre 115 avec le même angle important (sensiblement 30° dans l'exemple) et sont donc totalement réfléchis vers le silicium du photodétecteur 112.

En d'autres termes, la structure hybride combinant le réseau de diffraction 114 et le filtre interférométrique 115 forme une structure asymétrique permettant le non-retour (en provenance du substrat 101) d'un rayonnement NIR transmis, et donc le piégeage des photons dans le silicium du photodétecteur 112, pour un meilleure absorption de ceux-ci. Le rendement quantique QE du pixel est ainsi amélioré.

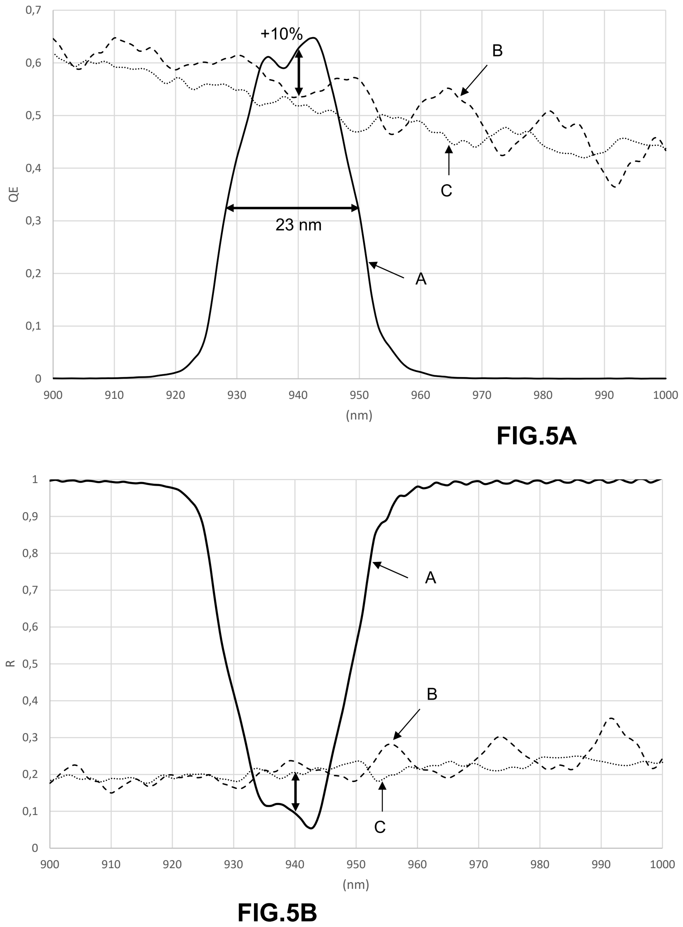

La **Figure 5A** illustre le rendement quantique QE d'un pixel rétroéclairé (de pitch 3,2 µm) muni du filtre interférométrique 115 des **Figure 4A** et **Figure 4B** et d'un réseau de diffraction 114 de pas 500 nm. Les courbes sont obtenues par le logiciel de simulation Lumerical précité, les pixels rétroéclairés étant illuminés à 940 nm par un cône d'illumination F#2. La courbe A représente le QE du pixel 110 doté du filtre interférométrique 115, la courbe B le QE du pixel sans le filtre interférométrique 115, et la courbe C le QE du pixel sans le filtre interférométrique 115 mais avec une microlentille conventionnelle positionnée en vis-à-vis du pixel (selon les techniques classiques). En effet, le pixel 110 utilisé dans le NIR peut être dépourvu de microlentille en vis-à-vis, contrairement aux techniques usuellement admises dans le domaine visible.

On observe un gain de 10 points du QE à 940 nm, permettant d'améliorer substantiellement la qualité du signal acquis, et donc de l'image acquise par le capteur d'images 100.

Ce gain de 10 points correspond à une réflexion divisée par deux à 940 nm comme montré sur la **Figure 5B** qui illustre la réflexion du pixel rétroéclairé sur les rayonnements en provenance de la scène - donc par la surface 115A du filtre interférométrique 115. A nouveau, la courbe A représente la réflexion en présence du filtre interférométrique 115, la courbe B la réflexion sans le filtre interférométrique 115, et la courbe C la réflexion sans le filtre interférométrique 115 mais avec une microlentille positionnée en vis-à-vis du pixel. La courbe de la **Figure 5B** est sensiblement complémentaire de la courbe de la **Figure 5A****.**

Le filtre interférométrique 115 utilisé pour les simulations des **Figures 4A, 4B****,** **5A** et **5B** offre une bonne transmission à 940 nm pour des angles d'incidence jusqu'à α₀=17-18°. Cela peut s'avérer insuffisant pour des agencements de capteur d'images mettant en œuvre des angles d'incidence supérieurs.

D'autres filtres interférométriques peuvent être conçus à l'aide par exemple du logiciel Optilayer pour obtenir un plus grand angle d'incidence minimal de réflexion (quasi-)totale α₀.

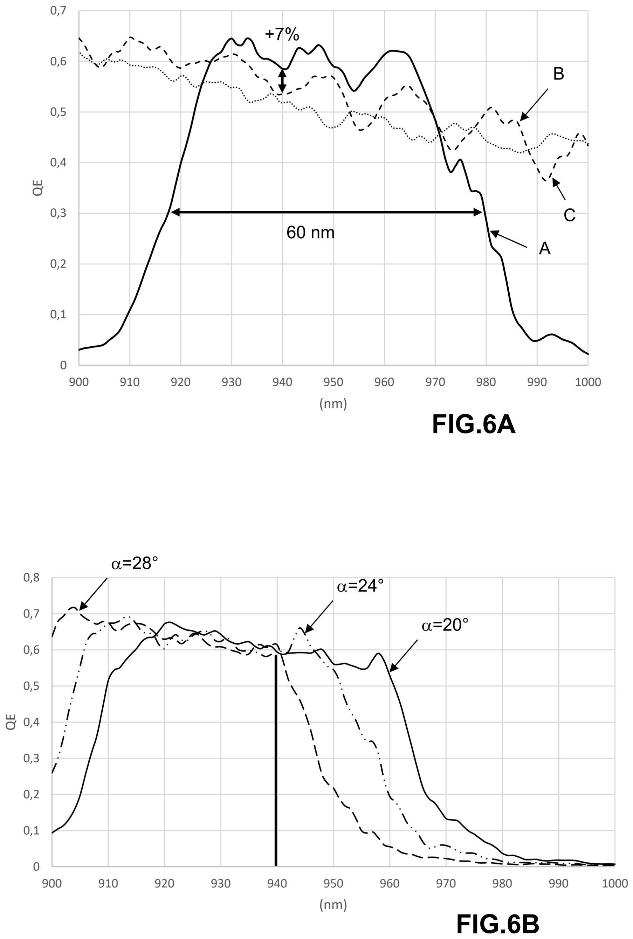

Les **Figure 6A** et **Figure 6B** représentent le rendement quantique QE d'un pixel rétroéclairé (de pitch 3,2 µm) muni d'un autre exemple de filtre interférométrique illuminé par un cône F#2.

Cet autre filtre interférométrique a été conçu sous les conditions de 940 nm, des matériaux SiO₂ et TA₂O₅, d'une largeur de bande supérieure à celle des figures précédentes pour avoir une transmission à 940 nm même à 30° d'incidence. Le filtre interférométrique obtenu est formé de 28 couches minces non-régulières alternées de SiO₂ et TA₂O₅, pour une épaisseur totale d'environ 4,3 µm.

La **Figure 6A** illustre le rendement quantique QE du pixel 110 en présence du filtre interférométrique 115 (courbe A) par opposition à un pixel sans le filtre interférométrique 115 (courbe B) et un pixel sans le filtre interférométrique 115 mais avec une microlentille positionnée en vis-à-vis du pixel (courbe C).

On observe un élargissement de la largeur de bande à mi-hauteur à 60 nm, tout en conservant un gain de 7 points du QE à 940 nm, permettant toujours d'améliorer substantiellement la qualité du signal acquis, et donc de l'image acquise par le capteur d'images 100.

**La** **Figure 6B** illustre le rendement quantique QE du pixel 110 en fonction de trois angles d'incidence du rayonnement en provenance de la scène, sur le filtre interférométrique 115, à savoir 20°, 24° et 28°.

On observe que la courbe de rendement quantique QE se décale vers les longueurs d'onde plus basses lorsque l'angle d'incidence augmente. Il est ainsi possible d'élargir la largeur de bande à mi-hauteur pour conserver un QE élevé pour une plage plus large d'angles d'incidence.

Dans l'exemple proposé, le rendement QE reste supérieur à 0,6 jusqu'à un angle de 28°. Ce filtre interférométrique 115 est adapté à un agencement de capteur d'images rétroéclairé dont l'angle du rayon principal ou Chief Ray Angle (CRA) en anglais est inférieur à 28°.

En élargissant la largeur de bande à mi-hauteur, il est ainsi possible d'obtenir un filtre interférométrique capable de transmettre les rayonnements incidents en provenance de la scène quelle que soit l'ouverture angulaire du cône d'illumination des pixels, tout en continuant de piéger les photons dans les pixels.

La **Figure 7** illustre, à l'aide d'un ordinogramme, des étapes de fabrication d'un capteur d'images doté de pixels semi-conducteurs rétroéclairés.

A l'étape 700, la structure hybride {réseau de diffraction 114, filtre interférométrique asymétrique 115} est conçue pour la longueur d'onde souhaitée, typiquement 940 nm, et des angles d'incidence souhaités. Cette conception peut être assistée par ordinateur.

Typiquement, un logiciel à couche mince est utilisé pour concevoir un filtre interférométrique 115 satisfaisant des contraintes telles qu'une bande de longueurs d'onde à filtrer, les angles d'incidence transmis par le filtre (par exemple, une transmission à 940 nm supérieure à un seuil jusqu'à 30°) et/ou une largeur de bande à mi-hauteur du filtre.

Une simulation de la transmission retour permet d'obtenir l'angle d'incidence minimal de réflexion (quasi-)totale α₁, typiquement l'angle limite de l'interface substrat-filtre.

Le réseau de diffraction 114 (notamment son pas) est alors déterminé de sorte qu'il diffracte une lumière incidente avec un angle supérieur à α₁. En d'autres termes, le réseau de diffraction 114 est conçue pour diffracter un rayonnement incident (à 940 nm par exemple) avec un angle diffracté qui est supérieur à l'angle (à la normale) minimal de réflexion (quasi-)totale α₁ du filtre interférométrique au niveau de l'interface avec le réseau de diffraction (ou substrat).

A l'étape 702, un substrat semiconducteur 101 dopé P est obtenu sur lequel sont réalisées des photodiodes 110a formant pixels. De façon connue, des tranchées d'isolation 113 séparent les photodiodes entre-elles, typiquement selon une formation en lignes et colonnes. Le substrat, au niveau de chaque pixel, est localement dopé N dans la région déjà dopée P pour former un jonction PN. Une électrode 111 est disposée à l'arrière du pixel pour former un pixel rétroéclairé 110a.

A l'étape 704, le réseau de diffraction 114 est formé sur la surface supérieure - donc éclairée - 102 de la photodiode 100b, conformément aux paramètres déterminés à l'étape 700. Un gravure (par voie sèche ou humide) est typiquement utilisée.

A l'étape 706, le filtre interférométrique 115 est formé au-dessus du réseau de diffraction 114 par le dépôt successif de couches minces non-régulières et alternées, d'indices de réfraction différents. Préférentiellement, chaque couche mince est déposée sur l'ensemble des photodiodes 100c formées sur le substrat 101, afin de réaliser en parallèle les photodiodes.

A l'étape 708, la matrice de photodiodes est découpée et intégrée avec un module optique et reliée à des circuits de contrôle et de décodage, pour former le capteur rétroéclairé d'images 100.

Bien entendu, la présente divulgation ne se limite pas aux formes de réalisation décrites ci-avant à titre d'exemples ; elle s'étend à d'autres variantes. D'autres réalisations sont possibles.

## Revendications

1. Pixel semiconducteur (110) comprenant :
un substrat (101),
un photodétecteur rétroéclairé (112) dans le substrat entre une première surface éclairé (102) du substrat et une deuxième surface (103) du substrat en contact avec une couche métallique et opposée à la première surface éclairée,
une structure de diffraction (114) sur le photodétecteur rétroéclairé, formée au niveau de la première surface éclairée du substrat, et
un filtre interférométrique (115) déposé sur la structure de diffraction.

2. Pixel semiconducteur (110) selon la revendication 1, dans lequel le filtre interférométrique (115) est formé d'un empilement de couches non-régulières.

3. Pixel semiconducteur (110) selon la revendication 1 ou 2, dans lequel le substrat est formé de silicium.

4. Pixel semiconducteur (110) selon l'une des revendications 1 à 3, dans lequel la structure de diffraction (114) est conçue pour diffracter un rayonnement incident de longueur d'onde donnée avec un angle diffracté qui est supérieur à un angle (α₁), à la normale, minimal de réflexion cible du filtre interférométrique (115) pour la longueur d'onde donnée au niveau de l'interface avec la structure de diffraction.

5. Pixel semiconducteur (110) selon l'une des revendications 1 à 4, dans lequel la structure de diffraction (114) comprend un réseau de diffraction réalisé sur la première surface éclairée (102) du photodétecteur rétroéclairé (112).

6. Pixel semiconducteur (110) selon la revendication 5, dans lequel le réseau de diffraction (114) présente un pas compris entre 400 et 500 nm.

7. Pixel semiconducteur (110) selon l'une des revendications 1 à 6, dans lequel le substrat (101) comprend une tranchée d'isolation (113) autour du photodétecteur rétroéclairé (112) pour l'isoler optiquement d'un ou plusieurs photodétecteurs rétroéclairés de pixels adjacents.

8. Capteur d'images (100) comprenant une pluralité de pixels semiconducteurs (110) selon l'une des revendications précédentes.

9. Procédé de fabrication d'un pixel semiconducteur (110), comprenant les étapes suivantes :
former (702) un photodétecteur rétroéclairé (112) dans un substrat (101), entre une première surface éclairée (102) du substrat et une deuxième surface (103) du substrat en contact avec une couche métallique et opposée à la première surface éclairée,
former (704) une structure de diffraction (114) sur le photodétecteur rétroéclairé au niveau de la première surface éclairée du substrat, et
former (706), par dépôts successifs de couches minces, un filtre interférométrique (115) sur la structure de diffraction.
